Europäisches Patentamt

(19) **European Patent Office**

**Office européen des brevets**

(11) Publication number: **0 171 264**
**A2**

(12) **EUROPEAN PATENT APPLICATION**

(21) Application number: **85305497.1**

(22) Date of filing: **01.08.85**

(51) Int. Cl.⁴: **H 03 K 17/22**

(30) Priority: **03.08.84 US 637457**

(43) Date of publication of application: **12.02.86**
**Bulletin 86/7**

(84) Designated Contracting States: **AT BE CH DE FR GB IT LI LU NL SE**

(71) Applicant: **ADVANCED MICRO DEVICES, INC., 901 Thompson Place P.O. Box 3453, Sunnyvale, CA 94088 (US)**

(72) Inventor: **Cornell, Barry, 111 North Rengstorff Avenue Apartment 110, Mountain View California 94043 (US)**

(74) Representative: **Wright, Hugh Ronald et al, Brookes & Martin High Holborn House 52/54 High Holborn, London WC1V 6SE (GB)**

(54) A power-up circuit for sequential logic device.

(57) An improved power-up circuit is disclosed for steering or initializing sequential logic circuits wherein the use of an SCR loop in the power-up circuitry lowers the threshold turn-off voltage of the power-up circuit after initial power-up so that inadvertent reactivation of the power-up circuit by low voltage spikes from a noisy power supply will be inhibited.

0171264

- 1 -

A POWER-UP CIRCUIT FOR SEQUENTIAL LOGIC DEVICES

This invention relates to an electronic circuit for a logic device. More particularly, this invention relates to an improved power-up circuit for a sequential logic device to provide a high noise threshold before reactivation of the power-up circuit.

It is often desirable to steer or set sequential logic circuits such as used in registers into a known state during power-up sequences. This can prove very useful in avoiding unwanted state vectors from occurring in a system design prior to an initial clock pulse when power is first applied to a circuit. For example, if multiple register outputs are connected to a common data bus, then bus contention problems could arise if more than one register powers up in the active or enabled state. This can occur since sequential logic circuits, by definition, are a function not only of inputs, but of previous state information. However, since there is no previous state during a power-up sequence, such a logic circuit will power-up in an undefined state unless some other circuit means is implemented to overcome this problem.

Preferably, it is desirable to provide a circuit for defining the state of the logic circuits when power is applied which is independent of all other inputs since other inputs may also not be initially defined during the power-up sequence.

0171264

— 2 —

Typically, in the prior art, the solution to this problem has been the addition of some combinational logic to an otherwise sequential logic design to provide the necessary control signal during power-up to steer the sequential logic into the desired state. An initialize or INIT signal is generated when Vcc, the normal operating voltage which is typically 4.5 to 5.5 volts for TTL circuits, reaches an initial turn-on or enable threshold voltage $V_1$. However, to insure that the INIT pulse does, indeed, set the flip-flop, the INIT signal must remain on until Vcc has subsequently reached a level $V_2$ to permit the flip-flop to become latched. Furthermore, the INIT signal must become disabled at some yet higher voltage $V_3$ prior to Vcc reaching its minimum operating voltage and then stay disabled as long as Vcc stays within its operating range, i.e., as long as the system is on. $V_2$ must, therefore, be higher than $V_1$, but lower than $V_3$.

Such power-up circuitry can present problems, however, due to noise in the power supply line in the form of negative voltage spikes because the $V_3$ INIT disabling voltage level is, of necessity, higher than the threshold voltage $V_2$ needed to set the flip-flops, yet lower than the normal operating voltage. Thus, an unwanted INIT signal could be accidently initiated during normal operations if a negative voltage spike resulted in Vcc dropping below $V_3$. In essence then, the addition of such power-up circuitry results in the normal logic circuits becoming more noise sensitive, due to this higher threshold, than they would be normally if there were no power-up circuitry.

Ideally, then, it would be desirable to provide circuitry to initialise or steer the sequential logic without reducing the noise margin of the circuit with respect to noise in the power supply.

The present invention provides a power-up circuit to initialise one or more sequential logic circuits without reducing the noise margin of the logic circuit being initialised characterised by an initial high cut-off voltage for the power-up circuitry and means for lowering this cut-off voltage during normal operations.

The present invention also provides a power-up circuit to initialise one or more sequential logic circuits without reducing the noise margin of the logic circuit being initialised characterised by an initial high cut-off voltage for the power-up circuitry and means for lowering this cut-off voltage during normal operations comprising an SCR latch type circuit which provides a saturation loop to lower the threshold voltage for reinitiation of the power-up circuit.

The present invention also provides a power-up circuit to initialise one or more sequential logic circuits without reducing the noise margin of the logic circuit being initialised comprising a first transistor which is activated to provide a steering signal to said logic circuits when said operating voltage rises to a first predetermined level, and second and third transistors having their respective bases coupled to the collector of the other to form an SCR loop which will provide a saturation or feedback loop to shut off the first transistor and lower the threshold voltage for reinitiation of the initialisation signal.

- 4 -

The invention may provide power-up circuitry to initialise one or more sequential logic circuits without reducing the noise margin of the logic circuit being initialised by providing an initial high cut-off voltage for the power-up circuitry and means for subsequently lowering this cut-off voltage during normal operations.

The invention may provide power-up circuitry to initialise one or more sequential logic circuits without reducing the noise margin of the logic circuit being initialised by providing an initial high cut-off voltage for the power-up circuitry and means for subsequently lowering this cut-off voltage during normal operations by using an SCR latch type circuit as a part of the power-up circuit.

The invention may provide power-up circuitry to initialise one or more sequential logic circuits without reducing the noise margin of the logic circuit being initialized by providing an intial high cut-off voltage for the power-up circuitry and means for subsequently lowering this cut-off voltage during normal operations comprising an SCR latch type circuit as a part of the power-up circuit wherein a saturation or feedback loop disables the power-up circuit and lowers the threshold voltage for reinitiation of the power-up circuit.

These and other features of the invention will be apparent from the following description and appended drawings.

## BRIEF DESCRIPTION OF THE DRAWINGS

Figure 1 is a schematic view of a prior art power-up circuit.

Figure 2 is a schematic view of a basic embodiment of the power-up circuit of the invention.

Figure 3 is a graph depicting the voltage levels during power-up and normal operations.

Figure 4 is a schematic view of an alternate embodiment of the invention.

## DESCRIPTION OF THE INVENTION

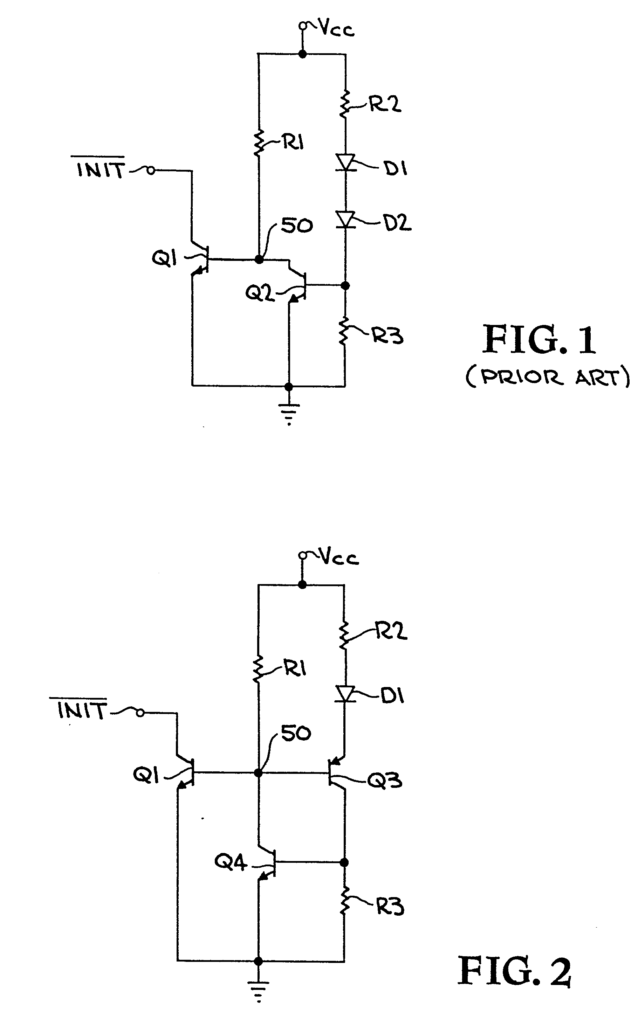

As previously discussed, the use of prior art power-up circuits could result in an increased noise sensitivity due to the high threshold voltage

0171264

-6-

used to disable the power-up circuit. Figure 1 shows such a prior art circuit wherein the operating voltage Vcc causes a transistor Q1 to conduct and thus provide the power-up voltage (labelled INIT in figure 1) when Vcc reaches $V_1$, i.e., the forward bias potential of one P-N junction.

Transistor Q1 continues to conduct as Vcc continues to rise through voltage $V_2$ which allows the flip-flops in the sequential logic circuits being initialized to become latched. However, when Vcc reaches voltage level $V_3$, which in the illustrated circuit is equivalent to 3 times a single P-N junction voltage plus the voltage drop across resistor R2, transistor Q2 is forward biased to conduct which turns off transistor Q1 and thereby disables the INIT signal. Vcc then continues to rise until it reaches the operating voltage of 4.5 to 5.5 volts.

In this prior art circuit, however, if Vcc should subsequently drop, for example, due to a negative voltage spike from a noisy power supply, transistor Q2 will cease to conduct and transistor Q1 will then begin to conduct again to provide an unwanted INIT signal. This threshold or cut-off voltage, Vth or $V_3$, can be represented as:

$$Vth = Vbe(Q2) + Vbe(D1) + Vbe(D2) + Vbe(Q2)*R2/R3$$

The above equation assumes a sufficiently high DC current gain for the transistors used in the illustrated circuit such that the base currents can be neglected for threshold calculations, and this assumption will be employed throughout this description.

The term Vbe as used herein is the base-emitter voltage drop across a particular transistor or diode and is, therefore, intended to represent a voltage equivalent to the approximate voltage drop across 1 P-N junction.

The term INIT or initialize can be defined as a steering signal which may, upon power-up, either set or reset each flip flop depending on the designer's choice.

Turning now to figure 2, the power-up circuitry of the invention is illustrated. Transistor Q1 is again initially biased to conduct when Vcc reaches a voltage level of 1 P-N junction. In the circuit of the invention, however, transistor Q2 is replaced by two transistors Q3 and Q4, which have their respective bases connected to the collector of the other transistor to form an SCR circuit providing a hysteresis threshold loop. As Vcc continues to rise, transistor Q3 turns on which subsequently turns on transistor Q4 causing a saturation loop to form thus shutting off transistor Q1 because the voltage drops to approximately zero at point 50 caused by the saturation of transistor Q4.

In order to turn transistor Q4 on, though, Vcc must first reach a level that forward biases the emitter-base junction of transistor Q3 which, in the example, will occur when Vcc reaches 3 Vbe, i.e., 3 times the P-N junction voltage, since the base of

-8-

transistor Q3 is at 1 Vbe and diode D1 is in series with the emitter of transistor Q3. At this point transistor Q3 begins to supply collector current to resistor R3.

Transistor Q4 will not turn on yet, however, until its base potential reaches 1 Vbe. Thus the Vcc threshold at which transistor Q4 turns on is further boosted by 1 Vbe times the ratio of resistor R2 to resistor R3. This is represented by the equation:

$$Vth = Vbe(Q1) + Vbe(Q3) + Vbe(D1) + Vbe(Q4)*R2/R3$$

When this threshold is reached and transistor Q4 is turned on, the circuit becomes an SCR-type latch and transistor Q4 is driven into saturation. Due to the nature of the SCR circuit, the circuit will remain in a latched state until Vcc drops low enough to turn off the emitter-base junction of transistor Q3. Since transistor Q4 is now saturated, this threshold is now lower than the turn-on threshold of transistor Q4 by the difference between 1 Vbe and the saturated voltage of transistor Q4. Since this difference represents almost a full base-emitter drop, since Vsat(Q4) approaches 0, the noise margin of the power-up circuit is increased by that amount which should lower its noise threshold below that of the sequential logic that it drives.

In comparing this with the equation for the prior art threshold voltage Vth, it will be seen that the prior art threshold voltage was the equivalent of 3 Vbe plus the voltage drop across resistor R2 while

-9-

Vth' above is the equivalent of approximately 2 Vbe plus the voltage across resistor R2, thus providing 1 Vbe of hysteresis in the threshold loop.

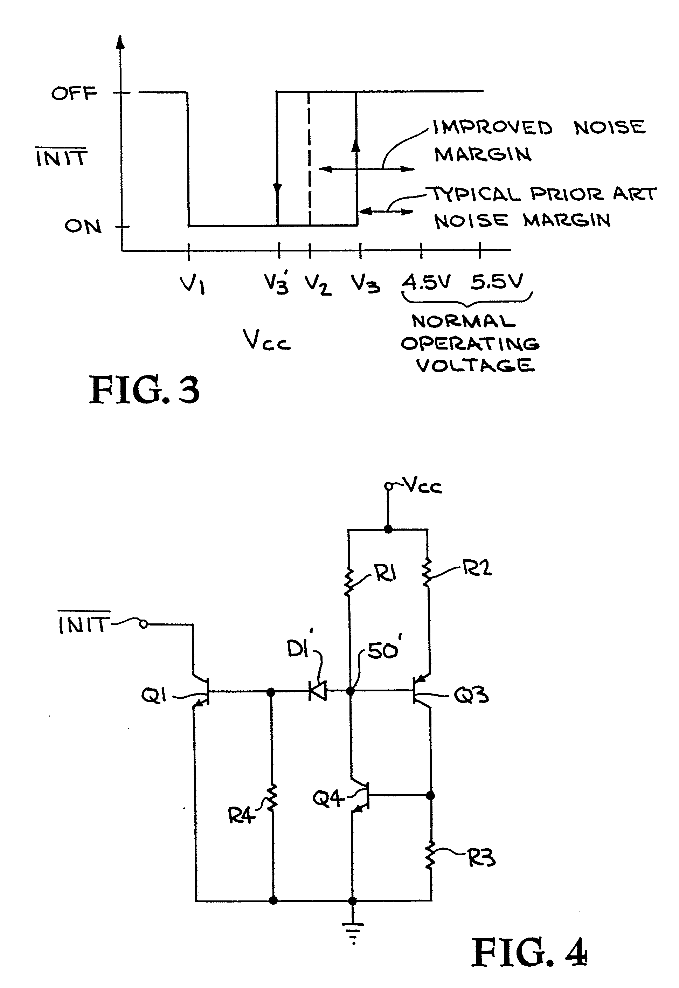

Figure 3 graphically illustrates the operation of the invention. As the operating voltage, Vcc, begins to rise during power-up, it first reaches $V_1$ at which time the INIT signal used to steer the flip-flops to a preferential state is turned on. Vcc then reaches $V_2$ where the flip-flops will then become latched. Vcc continues to rise to $V_3$ where the INIT signal is disabled prior to Vcc reaching its operating level of 4.5 to 5.5 volts. At the Vcc voltage level of $V_3$ where the INIT signal is turned off, the SCR circuit is activated to saturate the SCR transistors Q3 and Q4 as previously described. This lowers the voltage at point 50 (shown in figure 2) thus lowering the turn-off voltage for the INIT signal from $V_3$ to a new level $V_3'$. The new voltage threshold Vth' ($V_3'$ in the graph of figure 3) can thus be expressed as:
$$Vth' = Vsat(Q4) + Vbe(Q3) + Vbe(D1) + Vbe(Q4)*R2/R3$$

This lowering of the threshold from $V_3$ to $V_3'$, in turn, considerably increases the noise margin as shown in the graph to a point where the controlling lower limit is the voltage level $V_2$ below which the flip-flops will not latch, i.e., the noise margin before introduction of the power-up circuitry.

The circuit configuration of the invention shown in figure 2 may be further modified to provide even greater amounts of hysteresis in the turn-on and turn-off thresholds of the SCR latch. As shown in

0171264

-10-

figure 4, a diode D1' could be added between point 50 and the base of transistor Q1 and diode D1 eliminated. This embodiment would allow lowering of the Vth' threshold to Vth'' while maintaining the same Vth. This would, however, raise the turn-on voltage, $V_1$, for the INIT signal by 1 P-N junction. The equation for the new threshold voltage is:

Vth'' = Vsat(Q4) + Vbe(Q3) + Vbe(Q4)*R2/R3

In addition, the turn-on threshold of the SCR circuit may be varied by adding or removing series diodes in the emitter circuit of transistor Q3 and by varying the ratio of resistors R2 to R3. Other minor modifications to the illustrated circuitry will be apparent to those skilled in the art without departing from the teachings of the invention that an SCR circuit can be used to provide an initial high turn-off or cut-off of the power-up signal which, upon activation of the SCR hysteresis loop, drops to a lower turn-off theshold thus lowering the threshold voltage at which the INIT signal would be reactivated.

Thus the invention permits the use of a power-up circuit in sequential logic circuits without increasing the risk of loss of data due to an inadvertent reactivation or turn-on of the power-up circuit during operation due to a low voltage spike from a noisy power supply.

Having thus described the invention, what is claimed is:

-11-

CLAIMS

1. A power-up circuit to initialize one or more sequential logic circuits without reducing the noise margin of the logic circuit being initialized characterized by an initial high cut-off voltage for the power-up circuitry and means for lowering this cut-off voltage during normal operations.

2. The power-up circuit of claim 1 wherein said means for lowering the cut-off voltage of said power-up circuitry during normal operations comprises an SCR latch type circuit as a part of the power-up circuit.

3. The power-up circuit of claim 2 wherein said SCR latch type circuit provides a saturation or feedback loop which disables the power-up circuit and lowers the threshold voltage for reinitiation of the power-up circuit.

4. The power-up circuit of claim 3 wherein a first transistor is activated to provide a reset signal to said logic circuits when said operating voltage rises to a first predetermined level.

5. The power-up circuit of claim 4 wherein said first predetermined level is below the level at which the flip-flops in said logic circuits will latch.

6. The power-up circuit of claim 5 wherein second and third transistors are also used in said power-up circuit, said second and third transistors having their respective bases coupled to the collector of the other to form an SCR circuit loop.

0171264

-12-

7. The power-up circuit of claim 6 wherein the base of said second transistor and the collector of said third transistor are connected to the base of said first transistor whereby activation of said second and third transistor will form a saturation loop to lower the base voltage of said first transistor to shut it off and thus turn off the power-up signal to said logic circuits.

8. The power-up circuit of claim 7 wherein the saturation loop formed by said second and third transistors will lower the cut-off voltage of said power-up circuit whereby inadvertant lowering of the operating voltage to a level below the initial cut-off voltage of said power-up circuit will not result in reactivation of said power-up circuit.

9. A power-up circuit to initialize one or more sequential logic circuits without reducing the noise margin of the logic circuit being initialized characterized by an initial high cut-off voltage for the power-up circuitry and means for lowering this cut-off voltage during normal operations comprising an SCR latch type circuit which provides a saturation loop to lower the threshold voltage for reinitiation of the power-up circuit.

10. The power-up circuit of claim 9 wherein said SCR latch type circuit comprises a pair of transistors having their respective bases coupled to the collector of the other to form said SCR loop.

0171264

-13-

11. The power-up circuit of claim 10 wherein the saturation loop formed by said transistors will lower the cut-off voltage of said power-up circuit whereby inadvertant lowering of the operating voltage to a level below the initial cut-off voltage of said power-up circuit will not result in reactivation of said power-up circuit.

12. A power-up circuit to initialize one or more sequential logic circuits without reducing the noise margin of the logic circuit being initialized comprising a first transistor which is activated to provide a steering signal to said logic circuits when said operating voltage rises to a first predetermined level, and second and third transistors having their respective bases coupled to the collector of the other to form an SCR loop which will provide a saturation or feedback loop to shut off the first transistor and lower the threshold voltage for reinitiation of the initialization signal.

0171264

FIG. 1

(PRIOR ART)

FIG. 2

1/2

0171264

FIG. 3

FIG. 4

2/2